# EUROPÄISCHE PATENTANMELDUNG

(11) **EP 4 518 354 A1**
(43) Veröffentlichungstag der Anmeldung: **05.03.2025**
(21) Anmeldenummer: 24196912.0
(22) Anmeldetag: 28.08.2024
(51) Int. Cl.: H04R 19/00, H04R 17/00, H04R 7/10, B81B 3/00

(54) **MEMS-SCHALLWANDLER UND DESSEN HERSTELLUNGSVERFAHREN**

(30) Priorität: 29.08.2023 DE 102023123231; 19.09.2023 DE 102023125392
(71) Anmelder: USound GmbH, 8020 Graz (AT)
(72) Erfinder: RUSCONI CLERICI BELTRAMI, Andrea, 1130 Wien (AT); BOTTONI, Ferruccio, 8020 Graz (AT); NOVOTNY, Christian, 1120 Wien (AT); HORVÁTH, Samu Bence, 1020 Wien (AT)
(74) Vertreter: Canzler & Bergmeier Patentanwälte Partnerschaft mbB

(57) **Zusammenfassung**

Die Erfindung betrifft einen MEMS-Schallwandler (1), insbesondere zum Erzeugen und/oder Er-fassen von Schallwellen im hörbaren Wellenlängenspektrum und/oder im Ultraschallbereich, mit einem Träger (2) und mit zumindest einem am Träger (2) angeordneten und in Richtung einer Hubachse (3) auslenkbaren Piezoelement (4, 17), das zumindest eine Piezoschicht (5, 25) und zumindest eine Strukturschicht (6, 31) aufweist, wobei mittels der zumindest einen Piezoschicht (5, 25) elektrische Signale und Auslenkungen des Piezoelements (4) ineinander umwandelbar sind. Erfindungsgemäß ist die zumindest eine Piezoschicht (5, 25) aus Scandium-Aluminium-Nitrit ausgebildet. Des Weiteren betrifft die Erfindung ein Verfahren zur Herstellung eines MEMS-Schallwandlers (1).

## Beschreibung

Die vorliegende Erfindung betrifft einen MEMS-Schallwandler, insbesondere zum Erzeugen und/oder Erfassen von Schallwellen im hörbaren Wellenlängenspektrum und/oder im Ultraschallbereich, mit einem Träger und mit zumindest einem am Träger angeordneten und in Richtung einer Hubachse auslenkbaren Piezoelement, das zumindest eine Piezoschicht und zumindest eine Strukturschicht aufweist, wobei mittels der zumindest einen Piezoschicht elektrische Signale und Auslenkungen des Piezoelements ineinander umwandelbar sind.

Aus dem Stand der Technik sind Piezoelemente bekannt, die Piezoschichten aus PZT umfassen.

Aufgabe der Erfindung ist es, leistungsfähige MEMS-Schallwandler zu schaffen.

Die Aufgabe wird gelöst durch einen MEMS-Schallwandler und dessen Herstellungsverfahren mit den Merkmalen der unabhängigen Patentansprüche.

Vorgeschlagen wird ein MEMS-Schallwandler, insbesondere zum Erzeugen und/oder Erfassen von Schallwellen im hörbaren Wellenlängenspektrum und/oder im Ultraschallbereich. Der MEMS-Schallwandler kann somit als Lautsprecher und/oder als Mikrofon betrieben werden.

Der MEMS-Schallwandler umfasst einen Träger.

Des Weiteren umfasst der MEMS-Schallwandler zumindest ein am Träger angeordnetes und in Richtung einer Hubachse auslenkbares Piezoelement.

Außerdem weist der MEMS-Schallwandler zumindest eine Piezoschicht und zumindest eine Strukturschicht aufweist, wobei mittels der zumindest einen Piezoschicht elektrische Signale und Auslenkungen des Piezoelements ineinander umwandelbar sind.

Ferner ist die zumindest eine Piezoschicht aus Scandium-Aluminium-Nitrit ausgebildet. Derartige Piezoschichten sind sehr robust, was insbesondere an dem Scandiumanteil liegt, der vorzugsweise zwischen 10 % und 40 % betragen kann.

Gemäß einer vorteilhaften Weiterbildung der Erfindung ist es nützlich, wenn die zumindest eine Strukturschicht aus einem Polymer ausgebildet ist. Das Polymer kann hierbei ein Polyamid sein. Mit Hilfe der zumindest einen Strukturschicht aus Polymer können höhere Auslenkungen des Piezoelements erreicht werden. Zusätzlich oder alternativ kann auch eine Länge des Piezoelements verkürzt werden, wobei die Auslenkungen zumindest konstant gehalten werden können.

Es ist vorteilhaft, wenn das Piezoelement eine Kompensationsschicht aufweist. Mit Hilfe der Kompensationsschicht kann eine mechanische Spannung der Strukturschicht aus dem Polymer angepasst werden. Aufgrund der Strukturschicht aus dem Polymer ist diese bestrebt, sich zusammenzuziehen. Die zumindest eine Strukturschicht kann aufgrund der Eigenschaften beim Herstellen und/oder des Polymers eine interne mechanische Spannung aufweisen, die bestrebt ist, die Strukturschicht zusammenzuziehen. In einem Ruhezustand würde sich das Piezoelement nach oben bzw. in Richtung der Strukturschicht verbiegen. Mit Hilfe der Kompensationsschicht können die mechanischen Spannungen kompensiert werden. Die Kompensationsschicht weist hierbei eine mechanische Spannung auf, die der zumindest einen Strukturschicht entgegenwirkt, diese kompensiert und/oder ausgleicht. Die Kompensationsschicht dient somit zum Ausgleichen von mechanischen Spannungen der zumindest einen Strukturschicht. Zusätzlich oder alternativ dient die Kompensationsschicht zum Strecken der zumindest einen Strukturschicht. Die Kompensationsschicht hält hierbei die zumindest eine Strukturschicht in der gestreckten Ausrichtung und verhindert hierbei, dass sich die Strukturschicht aufgrund von eingeprägten mechanischen Spannungen wie ein Gummiband zusammenzieht und sich hierbei verformt. Zusätzlich oder alternativ dient die Kompensationsschicht zum Verhindern des Zusammenziehens der zumindest einen Strukturschicht aus dem Polymer. Die Kompensationsschicht wirkt der mechanischen Spannung der zumindest einen Strukturschicht aus Polymer entgegen und/oder ist stärker und/oder fester als die mechanische Spannung der zumindest einen Strukturschicht. Infolgedessen wird das Zusammenziehen der zumindest einen Strukturschicht verhindert. Die von der zumindest einen Strukturschicht aus Polymer wirkende Kraft und die Kraft durch die Kompensationsschicht wirken zueinander entgegengesetzt und/oder gleichen sich vorteilhafterweise aus und/oder heben sich gegenseitig auf. Dies verhindert hierbei das Zusammenziehen der Strukturschicht. Allerdings verhindert die Kompensationsschicht nicht das Auslenken des Piezoelements. Die mechanische Spannung der Kompensationsschicht wird derart eingestellt, dass diese das gummiartige Zusammenziehen der Strukturschicht verhindert bzw. ausgleicht bzw. kompensiert. Des Weiteren kann die Kompensation dazu dienen, dass in einer Ruhestellung des Piezoelements dieses einen spannungsfreien Zustand aufweist.

Des Weiteren kann mit Hilfe der Kompensationsschicht eine neutrale Schicht bzw. eine neutrale Ebene des Piezoelements positioniert werden. Das Piezoelement ist ein Kragarm und bei der Auslenkung des Piezoelements bilden sich darin eine Druck- und eine Zugspannung auf. Die Bereiche der Druck- und der Zugspannung hängen davon ab, ob sich das Piezoelement nach oben oder nach unten auslenkt. Auf der Seite, in dessen Richtung sich das Piezoelement auslenkt, werden die Druckspannungen ausgebildet. Auf der dazu gegenüberliegenden Seite bilden sich die Zugspannungen auf. Dies ist ein allgemeines Prinzip der Festigkeitslehre. In einer Ebene im Piezoelement, nämlich in der neutralen Ebene bzw. in der neutralen Schicht, heben sich die Zug- und die Druckspannung gegenseitig auf, so dass dort keine Spannung herrscht. Die Auslenkeigenschaften des Piezoelements hängen jedoch davon ab, an welchem Ort sich diese neutrale Ebene bzw. neutrale Schicht im Piezoelement befindet. Durch Veränderung von mechanischen Eigenschaften der Kompensationsschicht kann die Position der neutralen Ebene bzw. der neutralen Schicht angepasst werden. Beispielsweise kann die Kompensationsschicht dicker oder dünner ausgebildet werden, um die neutrale Ebene bzw. neutrale Schicht zu verschieben. Diese Verschiebung bzw. Positionierung der neutralen Ebene bzw. der neutralen Schicht erfolgt hierbei parallel zur Hubachse. Die neutrale Ebene bzw. neutrale Schicht kann hierdurch parallel zur Hubachse verschoben werden.

Vorteile bringt es mit sich, wenn in Richtung der Hubachse die Piezoschicht zwischen dem Träger und der Strukturschicht angeordnet ist.

Es ist förderlich, wenn die Strukturschicht zwischen der Piezoschicht und der Kompensationsschicht angeordnet ist.

Es ist von Vorteil, wenn die Kompensationsschicht aus einem Metall, insbesondere Gold, und/oder Siliziumdioxid, insbesondere TEOS, ausgebildet ist. Hierdurch kann die Kompensationsschicht vorteilhaft ausgebildet werden.

Es bringt Vorteile, wenn das Piezoelement in dessen Längsrichtung eine Länge, insbesondere vom Träger bis zu einem freien Ende des Piezoelements, zwischen 0,5 mm und 2 mm aufweist.

Es ist förderlich, wenn sich die Kompensationsschicht in einer Längsrichtung des Piezoelements bis an den Träger und/oder an das freie Ende des Piezoelements erstreckt.

Vorteilhaft ist es, wenn das zumindest eine Piezoelement mehrere, insbesondere zwischen zwei und sechs, vorzugsweise vier, Piezoschichten umfasst.

Ein Vorteil resultiert, wenn das zumindest eine Piezoelement zumindest eine Elektrodenschicht umfasst. Mit Hilfe der zumindest einen Elektrodenschicht können die elektrischen Signale ausgetauscht werden, die zur Auslenkung des Piezoelements führen und/oder die ausgebildet werden, wenn das Piezoelement ausgelenkt wird.

Von Vorteil ist es, wenn das zumindest eine Piezoelement zumindest eine Isolationsschicht umfasst.

Vorteilhaft ist es, wenn das zumindest eine Piezoelement sandwichartig aus den mehreren Piezoschichten und den Elektrodenschichten ausgebildet ist.

Ein Vorteil resultiert, wenn der MEMS-Schallwandler ein Koppelelement umfasst, mit dem das zumindest eine Piezoelement mit einer Membran koppelbar ist.

Eine Verbesserung resultiert, wenn das Piezoelement und das Koppelelement mittels zumindest eines Federelements miteinander gekoppelt sind, wobei das zumindest eine Federelement in Längsrichtung des Piezoelements vorzugsweise zwischen der Strukturschicht und dem Koppelelement angeordnet ist.

Vorteile bringt es mit sich, wenn das Federelement, vorzugsweise ausschließlich, durch die Strukturschicht und/oder dem Polymer ausgebildet ist. Hierdurch kann das Federelement auf einfache Weise ausgebildet werden. Zusätzlich oder alternativ weist das Federelement die mechanischen Eigenschaften des Polymers auf.

Es ist förderlich, wenn das Piezoelement und das Koppelelement zueinander denselben schichtweisen Aufbau aufweisen.

Ein Vorteil resultiert, wenn die Kompensationsschicht zwischen 0,2 µm und 4 µm dick ist. Ferner kann die Kompensationsschicht zwischen 0,5 µm und 3 µm dick sein. Weiterhin kann die Kompensationsschicht eine Dicke zwischen 0,6 µm und 2 µm aufweisen. Alternativ kann die Kompensationsschicht zwischen 1 µm und 2 µm dick sein. Hierdurch kann mit Hilfe der Kompensationsschicht das Zusammenziehen der Strukturschicht verhindert bzw. kompensiert werden.

Eine Verbesserung resultiert, wenn die Strukturschicht zwischen 10 µm und 50 µm dick ist.

Vorteilhaft ist es, wenn das zumindest eine Piezoelement zumindest eine Aussparung aufweist. Mit Hilfe der Aussparung können die mechanischen Eigenschaften des Piezoelements angepasst werden. Beispielsweise können hierdurch Spannungen des Piezoelements vermindert und/oder die Bewegungseigenschaften angepasst werden. Die zumindest eine Aussparung kann in der zumindest einen Piezoschicht, in der zumindest eine Elektrodenschicht, in der zumindest einen Isolationsschicht, in der zumindest einen Strukturschicht und/oder in der zumindest einen Kompensationsschicht angeordnet sein.

Des Weiteren ist es vorteilhaft, wenn die Strukturschicht aus dem Polymer ein E-Modul zwischen 2 und 50 GPa, insbesondere zwischen 2 - 5 GPa, vorzugsweise zwischen 3,5 und 4 GPa, aufweist.

Ein Vorteil resultiert, wenn die Strukturschicht aus dem Polymer eine Zugfestigkeit zwischen 70 und 100 MPa, insbesondere zwischen 85 und 95, MPa aufweist.

Durch die oben genannten mechanischen Eigenschaften der zumindest einen Strukturschicht können die Auslenkungen vergrößert und/oder das Piezoelement bei zumindest gleichbleibender Größe der Auslenkung oder bei Vergrößerung der Auslenkung verkürzt werden.

Des Weiteren ist es vorteilhaft, wenn die Kompensationsschicht einen gleich hohen oder zumindest minimal höheren mechanischen Spannungszustand als die zumindest eine Strukturschicht aufweist. Zusätzlich oder alternativ kann die Kompensationsschicht eine höhere Widerstandsfähigkeit als die Strukturschicht aufweisen. Der mechanische Spannungszustand der Kompensationsschicht kann einem mechanischen Spannungszustand der zumindest einen Strukturschicht entgegenwirken. Dadurch kann die Kompensationsschicht die zumindest eine Strukturschicht in der gestreckten Ausrichtung halten. Die Kompensationsschicht kann dadurch der Strukturschicht widerstehen bzw. verhindern, dass sich die Strukturschicht aufgrund der mechanischen Spannung zusammenzieht. Wenn mehrere Strukturschichten vorhanden sind, dann weist die Kompensationsschicht einen mechanischen Spannungszustand auf, der gleich oder höher ist als die Strukturschichten zusammen. Zusätzlich oder alternativ kann die Kompensationsschicht auch einen mechanischen Spannungszustand aufweisen, der dem Piezoelement entgegenwirkt bzw. bewirkt, dass das Piezoelement in einer neutralen Stellung spannungsfrei ist. Hierbei hängt der mechanische Spannungszustand von mehreren Faktoren ab. Der benötigte mechanische Spannungszustand der Kompensationsschicht hängt hierbei von der Dicke der Strukturschicht bzw. der Dicken aller Strukturschichten sowie einem E-Modul, der Zugfestigkeit und/oder der Elastizität der Strukturschicht bzw. des Polymers ab. Das Polymer kann hierbei eine Gummielastizität aufweisen, durch die die Strukturschicht bestrebt ist, sich zusammenzuziehen. Die Kompensationsschicht weist hierbei einen derartigen mechanischen Spannungszustand auf, dass dieser dem Zusammenziehen des Polymers entgegenwirken kann. Die Kraft, mit der sich das Polymer zusammenziehen will, hängt hierbei von der Dicke und der Stärke des Polymers, d.h. beispielsweise von der Stärke der Gummielastizität, ab. Der mechanische Spannungszustand der Kompensationsschicht hängt dabei ebenfalls von der Dicke und dem E-Modul bzw. der Druckfestigkeit der Kompensationsschicht ab.

Die Kompensationsschicht hat einen gleichen oder höheren mechanischen Spannungszustand als die Strukturschicht oder die Gesamtheit aller Strukturschichten und/oder der Piezoschichten. Dieser gleiche oder höhere mechanische Spannungszustand ermöglicht es der Kompensationsschicht, die Strukturschicht(en) und/oder die Piezoschichten in ihrer gestreckten Position zu halten und ihnen Stabilität zu verleihen. Die Kompensationsschicht dient dazu, der Tendenz der Strukturschicht entgegenzuwirken, sich aufgrund ihrer elastischen Eigenschaften zusammenzuziehen.

Vorteilhaft ist es, wenn der mechanische Spannungszustand der Kompensationsschicht der mechanischen Spannung der zumindest einen Strukturschicht und/oder der zumindest einen Piezoschicht entgegenwirkt, diese kompensiert und/oder ausgleicht. Beispielsweise kann die mechanische Spannung der Kompensationsschicht zwischen 50 MPa und 1000 MPa betragen. Ferner kann die mechanische Spannung der Kompensationsschicht zwischen 100 MPa und 300 MPa betragen. Des Weiteren kann die mechanische Spannung der Kompensationsschicht 240 MPa betragen.

Die erforderliche mechanische Spannung der Kompensationsschicht kann durch verschiedene Faktoren bestimmt sein. Dazu gehören die Dicke der Strukturschicht(en), das E-Modul (Elastizitätsmodul), die Zugfestigkeit und die Elastizität der Strukturschicht bzw. des Polymers. Eine dickere Strukturschicht benötigt eine entsprechend festere Kompensationsschicht und/oder eine Kompensationsschicht mit einer höheren mechanischen Spannung, um die elastischen Kräfte auszugleichen. Die Kompensationsschicht weist deshalb vorteilhafterweise die Fähigkeit auf, diesem Zusammenziehen entgegenzuwirken.

Die Kraft, mit der das Polymer bestrebt ist, sich zusammenzuziehen, hängt von mehreren Faktoren ab. Dazu gehören die Dicke des Polymers und die Stärke der elastischen Eigenschaft des Polymers. Ein dickeres Polymer erzeugt eine stärkere mechanische Spannung. Die mechanische Spannung der Kompensationsschicht wird ebenfalls durch ihre eigene Dicke und ihrem E-Modul bestimmt. Eine dickere Kompensationsschicht mit einem höheren E-Modul kann einer stärkeren mechanischen Spannung des Polymers entgegenwirken.

Die Kompensationsschicht ist vorteilhafterweise stark genug, um die elastischen Rückstellkräfte der Strukturschicht auszugleichen und somit die gesamte Struktur stabil zu halten.

Des Weiteren ist es von Vorteil, wenn die Kompensationsschicht eine Versteifungsstruktur aufweist. Beispielsweise kann die Kompensationsschicht eine streifenförmige Versteifungsstruktur aufweisen oder derart ausgebildet sein. Dadurch kann zum einen die nötige mechanische Spannung erzielt werden, um das Zusammenziehen der Strukturschicht zu verhindern. Andererseits kann damit Material eingespart und/oder beliebig platziert werden.

Förderlich ist es, wenn die Strukturschicht aus dem Polymer derart ausgebildet ist, dass eine Elongation zwischen 3 % und 10 % ausgebildet werden kann.

Vorgeschlagen wird außerdem ein Verfahren zur Herstellung eines MEMS-Schallwandlers, insbesondere zum Erzeugen und/oder Erfassen von Schallwellen im hörbaren Wellenlängenspektrum und/oder im Ultraschallbereich. Das Verfahren zur Herstellung des MEMS-Schallwandlers kann dabei derart durchgeführt werden, dass der MEMS-Schallwandler mit zumindest einem Merkmal der vorangegangenen und/oder nachfolgenden Beschreibung ausgebildet wird.

Beim Verfahren wird auf einem Träger zumindest ein Piezoelement ausgebildet, das zumindest eine Piezoschicht und zumindest eine damit gekoppelte Strukturschicht umfasst.

Außerdem kann zur Ausbildung der zumindest einen Strukturschicht ein Polymer auf der Piezoschicht angeordnet werden.

Die zumindest eine Piezoschicht wird aus Scandium-Aluminium-Nitrit ausgebildet.

Ferner ist es vorteilhaft, wenn das zumindest eine Piezoelement mit mehreren, insbesondere zwischen zwei und sechs, insbesondere vier, Piezoschichten ausgebildet wird.

Förderlich ist es, wenn das zumindest eine Piezoelement sandwichartig aus den mehreren Piezoschichten und zumindest einer Elektrodenschicht ausgebildet wird.

Die mehreren Piezoschichten und mehreren Elektrodenschichten können abwechselnd übereinander angeordnet sein.

Des Weiteren ist es vorteilhaft, wenn beim Ausbilden des zumindest einen Piezoelements zumindest eine Isolationsschicht angeordnet wird.

Nützlich ist es, wenn die Strukturschicht aus dem Polymer auf einer dem Träger abgewandten Seite der Piezoschicht angeordnet wird.

Eine Verbesserung resultiert, wenn die Strukturschicht aus dem Polymer auf der zumindest einen Piezoschicht angeordnet wird, nachdem die Piezoschicht und/oder ein Koppelelement ausgebildet sind und/oder nachdem der Träger, die Piezoschicht und/oder das Koppelelement, insbesondere mittels Ätzens, nachbearbeitet, insbesondere voneinander getrennt, sind.

Es ist förderlich, wenn das Piezoelement und das Koppelelement zusammen schichtweise ausgebildet werden, wobei dies vorzugsweise auf dem Träger erfolgt.

Es bringt Vorteile, wenn nach dem schichtweisen Aufbauen des Piezoelements und des Koppelelements diese, insbesondere mittels Ätzens, zumindest abschnittweise voneinander getrennt werden.

Des Weiteren ist es vorteilhaft, wenn die zumindest eine Strukturschicht aus dem Polymer auf die Piezoschicht und/oder das Koppelelement, insbesondere in Form einer, vorzugsweise selbstklebenden, Polymerfolie, auflaminiert wird.

Ein Vorteil resultiert, wenn zwei Strukturschichten ausgebildet werden, die vorzugsweise übereinander angeordnet sind und/oder die aus dem gleichen oder einem unterschiedlichen Polymer ausgebildet sind.

Vorteilhaft ist es, wenn das Auflaminieren der Strukturschicht aus dem Polymer bei einer Temperatur zwischen 70 °C und 90 °C erfolgt.

Es ist förderlich, wenn nach dem Auflaminieren ein Aushärtungsschritt des Polymers erfolgt, wobei dieser Aushärtungsschritt vorzugsweise bei einer Temperatur zwischen 150 °C und 200 °C und/oder für eine Dauer zwischen 0,5 und 2 Stunden erfolgt.

Gemäß einer vorteilhaften Weiterbildung der Erfindung ist es nützlich, wenn auf die Strukturschicht eine Kompensationsschicht angeordnet wird.

Nützlich ist es, wenn die zumindest eine Strukturschicht aus dem Polymer nachbearbeitet wird.

Weitere Vorteile der Erfindung sind in den nachfolgenden Ausführungsbeispielen beschrieben. Es zeigen:
- **Figur** 1: eine schematische Schnittansicht eines MEMS-Schallwandlers mit einem Piezoelement aus zumindest einer Piezoschicht und zumindest einer Strukturschicht,
- **Figur 2**: eine schematische Schnittansicht eines MEMS-Schallwandlers mit zwei Piezoelementen und einem Koppelelement,
- **Figur 3**: eine schematische Schnittansicht eines MEMS-Schallwandlers mit zwei Piezoelementen und zwei Koppelelementen,
- **Figur 4**: eine schematische Schnittansicht eines MEMS-Schallwandlers mit dessen schichtweisen Aufbau und
- **Figur 5**: eine Draufsicht auf einen MEMS-Schallwandler.

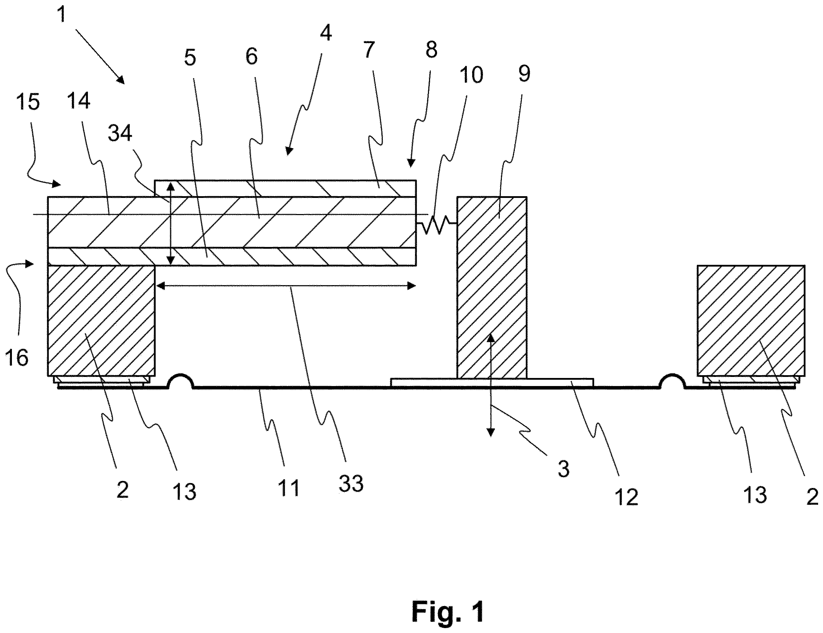

Figur 1 zeigt eine perspektivische Ansicht eines MEMS-Schallwandlers 1. Mittels des MEMS-Schallwandlers 1 können beispielsweise Schallwellen im hörbaren Wellenlängenspektrum erzeugt werden, so dass dieser als MEMS-Lautsprecher betrieben werden kann. Mit Hilfe des MEMS-Schallwandlers 1 können zusätzlich oder alternativ Schallwellen im hörbaren Wellenlängenspektrum erfasst werden, so dass dieser als MEMS-Mikrofon betrieben werden kann. Der MEMS-Schallwandler 1 kann ferner beispielsweise in einem Smartphone angeordnet sein, um beispielsweise das Telefonieren oder das Hören von Musik zu ermöglichen. Der MEMS-Schallwandler 1 kann beispielsweise auch in einem Kopfhörer angeordnet sein.

Ein weiteres Anwendungsgebiet des MEMS-Schallwandlers 1 kann aber auch die Erzeugung und/oder Erfassung von Schallwellen im Ultraschallbereich sein. Der MEMS-Schallwandler 1 kann beispielsweise in einem Ultraschallsensor, beispielsweise einem Abstandssensor, angeordnet sein.

Der MEMS-Schallwandler 1 umfasst ferner einen Träger 2, der ein Grundgerüst des MEMS-Schallwandlers 1 bilden kann. Der Träger 2 kann beispielsweise ein Halbleitersubstrat umfassen, das in einem Ätzverfahren hergestellt sein kann. Der Träger 2 kann beispielsweise aus Silizium ausgebildet sein und/oder die Form eines Wafers aufweisen. In der vorliegenden Ansicht sind zwei Träger 2 gezeigt. Der Träger 2 kann jedoch als Rahmen ausgebildet sein, sodass in dieser hier gezeigten Schnittansicht die beiden hier gezeigten Elemente des Trägers 2 zusammenhängend sind. Beispielsweise kann der Träger 2 in einer Draufsicht rechteckig ausgebildet sein. Die Draufsicht kann beispielsweise in Richtung einer im Folgenden erläuterten Hubachse 3 orientiert sein. Die Draufsicht kann beispielsweise parallel zur Achse 3 sein. Beispielsweise kann das zumindest eine Piezoelement 4 zumindest teilweise einem Inneren des Trägers 2 zugewandt sein, wenn der Träger 2 beispielsweise als Rahmen ausgebildet ist.

Am Träger 2 ist des Weiteren zumindest ein Piezoelement 4 angeordnet. Das zumindest eine Piezoelement 4 kann ferner mit dem Träger 2 gekoppelt sein. Das zumindest eine Piezoelement 4 kann entlang der gezeigten Hubachse 3 ausgelenkt werden. Das zumindest eine Piezoelement 4 kann dabei elektrische Signale in Auslenkungen umwandeln, so dass der MEMS-Schallwandler 1 als Lautsprecher betrieben wird bzw. die Schallwellen erzeugt werden können. Zusätzlich oder alternativ können mit Hilfe des zumindest einen Piezoelements 4 auch Auslenkungen in elektrische Signale umgewandelt werden, so dass der MEMS-Schallwandler 1 als Mikrofon betrieben wird bzw. die Schallwellen erfasst werden können.

Das zumindest eine Piezoelement 4 umfasst ein freies Ende 8, das sich entlang der Hubachse 3 auslenken kann.

Das Piezoelement 4 umfasst des Weiteren zumindest eine Piezoschicht 5. Die zumindest eine Piezoschicht 5 ist aus einem piezoelektrischen Material ausgebildet. Die zumindest eine Piezoschicht 5 kann elektrische Signale in Auslenkungen und/oder Auslenkungen in elektrische Signale wandeln. Die Piezoschicht 5 ist hier aus Scandium-Aluminium-Nitrit (ScAlN) ausgebildet.

Außerdem umfasst das Piezoelement 4 zumindest eine Strukturschicht 6. Diese ist mit der zumindest einen Piezoschicht 5 gekoppelt. Gemäß dem vorliegenden Ausführungsbeispiel ist die zumindest eine Strukturschicht 6 auf einer dem Träger 2 abgewandten Seite der zumindest einen Piezoschicht 5 angeordnet. Zusätzlich oder alternativ ist die zumindest eine Piezoschicht 5 zwischen dem Träger 2 und der zumindest einen Strukturschicht 6 angeordnet. Mit Hilfe der zumindest einen Strukturschicht 6 kann die zumindest eine Piezoschicht 5 stabilisiert werden. Ferner kann mittels der zumindest einen Strukturschicht 6 verhindert werden, dass die zumindest eine Piezoschicht 5 beim Auslenken bricht. Die zumindest eine Strukturschicht 6 kann auch als Trägerschicht für die zumindest eine Piezoschicht 5, 25 dienen.

Vorteilhaft ist es, wenn hier die Strukturschicht 6 aus einem Polymer ausgebildet ist. Die Strukturschicht 6 ist somit eine Polymerstrukturschicht. Bei dem Polymer kann es sich um ein Polyamid handeln. Ein Polymer ist, insbesondere im Vergleich zu Silizium, weicher, so dass das Piezoelement 4 kleiner ausgebildet werden kann, wobei trotzdem hohe Auslenkungen des Piezoelements 4 möglich sind. Eine Performance bzw. Leistung des Piezoelements 4 hängt unter anderem von der Stärke der Auslenkung oder auch von der Elongation ab. Durch das weiche Polymer, insbesondere im Vergleich zu Silizium, sind gleichbleibende Auslenkungen möglich, bei geringeren Abmessungen, insbesondere bei einer geringeren Länge, des Piezoelements 4.

Gemäß dem vorliegenden Ausführungsbeispiel umfasst das zumindest eine Piezoelement 4 zumindest eine Kompensationsschicht 7. Die Kompensationsschicht 7 kann Spannungen ausgleichen, die dadurch auftreten, dass sich die Strukturschicht 6 aus dem Polymer zusammenziehen will. Mit Hilfe der Kompensationsschicht 7 kann verhindert werden, dass sich durch das Zusammenziehen der Strukturschicht 6 aus dem Polymer das Piezoelement 4 in einem Ruhezustand nach oben bzw. in eine Richtung vom Träger 2 weg wölbt. Mit Hilfe der Kompensationsschicht 7 kann aber auch eine neutrale Ebene 14 (oder Schicht) des Piezoelements 4 angepasst werden. Die neutrale Ebene 14 ist ein Begriff aus der Festigkeitslehre und/oder Spannungslehre und wird auch als neutrale Faser bzw. Nulllinie bezeichnet. Die neutrale Faser bzw. neutrale Ebene 14 bzw. die Nulllinie ist dabei die Ebene bzw. Linie im Piezoelement 4, wo sich die Zug- und Druckspannung aufheben, so dass dort keine Spannung auftritt. Darüber und darunter wirken dagegen entweder Zug- oder Druckspannungen. Die Zug- oder Druckspannung tritt hierbei natürlich nur auf, wenn sich das Piezoelement 4 auslenkt. Wird das Piezoelement 4 beispielsweise nach oben, d. h. in Richtung vom Träger 2 weg, ausgelenkt, so wirkt in einem oberen Bereich des Piezoelements 4 Druckspannung und in einem unteren Bereich des Piezoelements 4 Zugspannung. Wenn sich dagegen das Piezoelement 4 nach unten, d. h. zum Träger 2 hin, ausgelenkt, so vertauschen sich die Druckspannung und die Zugspannung. In der neutralen Ebene 14 bzw. in der neutralen Schicht wirkt weder Zugspannung noch Druckspannung, wobei diese Ebene 14 bzw. diese Schicht zwischen einer Oberseite und einer Unterseite des Piezoelements 4 angeordnet ist. Mit Hilfe der Kompensationsschicht 7 kann die Position der neutralen Faser bzw. neutralen Ebene 14 (oder Schicht) bzw. der Nulllinie in der Höhe bzw. in Richtung der Hubachse 3 angepasst werden. Mit Hilfe der Kompensationsschicht 7, insbesondere den mechanischen Eigenschaften der Kompensationsschicht 7, d. h. mechanische Spannung, Dicke usw., kann die neutrale Ebene 14 in Richtung entlang der Hubachse 3 verschoben werden. Die neutrale Ebene 14 kann in Richtung einer Oberseite 15 des Piezoelements 4 oder in Richtung einer Unterseite 16 des Piezoelements 4 verschoben bzw. angeordnet werden. Die Unterseite 16 des Piezoelements 4 ist dem Träger 2 zugewandt. Dagegen ist die Oberseite 15 des Piezoelements 4 vom Träger 2 abgewandt.

Die Kompensationsschicht 7 kann beispielsweise aus einem Metall ausgebildet sein. Bei dem Metall kann es sich beispielsweise um Gold handeln. Zusätzlich oder alternativ kann die Kompensationsschicht 7 auch aus Siliziumdioxid, insbesondere TEOS, ausgebildet sein. Mit Hilfe dieser Materialien kann auf einfache Weise die mechanische Eigenschaft der Kompensationsschicht 7 ausgebildet werden.

Gemäß dem vorliegenden Ausführungsbeispiel umfasst der MEMS-Schallwandler 1 ein Koppelelement 9, mit dem das zumindest eine Piezoelement 4 mit einer hier gezeigten Membran 11 des MEMS-Schallwandlers 1 gekoppelt werden kann. Mithilfe des Koppelelements 9 können die Auslenkungen des Piezoelements 4 auf die Membran 11 übertragen werden, wenn mittels der Membran 11 die Schallwellen erzeugt werden. Zusätzlich oder alternativ können auch die Auslenkungen der Membranen 11, wenn mithilfe der Membran 11 die Schallwellen erfasst werden, auf das Piezoelement 4 übertragen werden.

Von Vorteil ist es, wenn, wie hier gezeigt ist, zwischen dem Koppelelement 9 und der Membran 11 eine Koppelplatte 12 angeordnet ist. Mittels der Koppelplatte 12 kann eine flächige Übertragung der Auslenkungen zwischen dem Koppelelement 9 und der Membran 11 erreicht werden. Gemäß dem vorliegenden Ausführungsbeispiel ist außerdem ein Membranrahmen 13 gezeigt, mit dem die Membran 11 auf dem Träger 2 angeordnet sein kann.

Des Weiteren weist das zumindest eine Piezoelement 4 eine Länge 33 auf. Die Länge 33 ist hier vom Träger 2 bis zu dem freien Ende 8 des zumindest einen Piezoelements 4 definiert. Die Länge 33 kann zwischen 0,5 mm und 2 mm betragen. Durch die Strukturschicht 6 kann das Piezoelement 4 diese Länge 33 aufweisen, wobei große Auslenkungen entlang der Hubachse 3 möglich sind. Die Auslenkung des zumindest einen Piezoelements 4, insbesondere an dem freien Ende 8, kann mindestens 3 %, vorzugsweise mindestens 10 %, betragen.

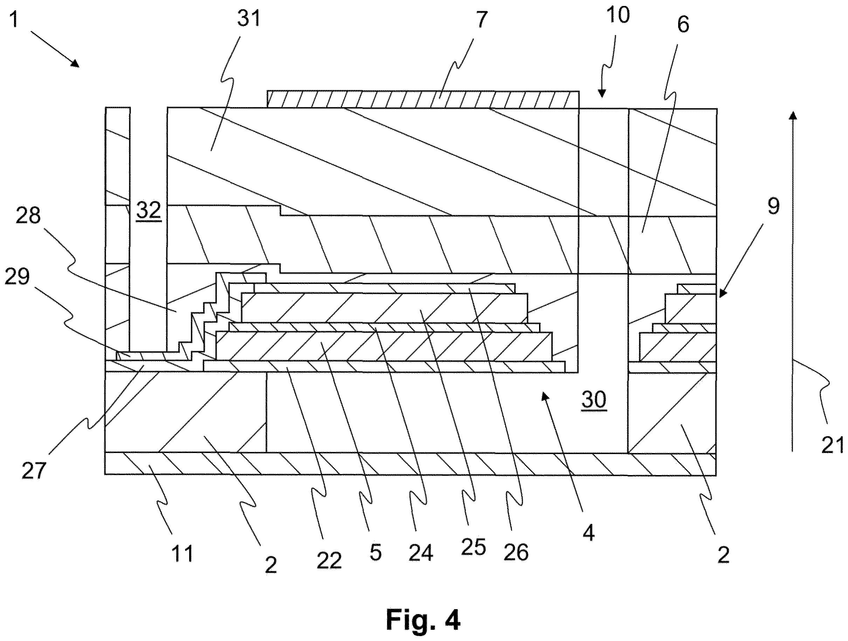

Eine Dicke 34 des zumindest einen Piezoelements 4 kann zwischen 2 µm und 50 µm betragen. Die Dicke 34 ist parallel zur Hubachse 3 und/oder senkrecht zu den Schichten des zumindest einen Piezoelements 4 orientiert (vgl. Figur 4). Eine Teildicke der zumindest einen Kompensationsschicht 7 kann hierbei zwischen 0,5 µm und 3 µm betragen. Wenn mehrere Kompensationsschichten 7 vorhanden sind, wie beispielsweise in der Figur 4 gezeigt ist, können diese mehreren Kompensationsschichten 7 zusammen eine Teildicke zwischen 0,5 µm und 3 µm aufweisen.

Des Weiteren kann das zumindest eine Piezoelement 4 zumindest eine in dieser Figur nicht gezeigte Aussparung 35 aufweisen. Die zumindest eine Aussparung 35 kann sich zumindest teilweise zwischen der Oberseite 15 und der Unterseite 16 erstrecken. Die zumindest eine Aussparung 35 kann sich von der Oberseite 15 und/oder von der Unterseite 16 in Richtung der entsprechend gegenüberliegenden Ober- bzw. Unterseite 15, 16 erstrecken. Mit Hilfe dieser Aussparungen 35 können Spannungen im Piezoelement 4 bzw. in der zumindest einen Piezoschicht 5, in der zumindest einen Strukturschicht 6 und/oder in der Kompensationsschicht 7 vermindert werden. Zusätzlich oder alternativ erstreckt sich die Aussparung 35 in Richtung der Hubachse 3.

Merkmale, welche bereits in der zumindest einen vorgegangenen Figur beschrieben sind, können der Einfachheit halber nicht nochmals erklärt werden. Ferner können Merkmale auch erst in dieser oder in zumindest einer der nachfolgenden Figuren beschrieben werden. Des Weiteren werden der Einfachheit halber für gleiche Merkmale gleiche Bezugszeichen verwendet. Außerdem können der Übersichtlichkeit halber nicht mehr alle Merkmale in den folgenden Figuren gezeigt und/oder mit einem Bezugszeichen versehen sein. Es können jedoch in einer oder mehreren der vorangegangenen Figuren gezeigte Merkmale auch in dieser oder in einer oder mehreren der nachfolgenden Figuren vorhanden sein. Ferner können der Übersichtlichkeit halber Merkmale auch erst in dieser oder in einer oder mehreren der nachfolgenden Figuren gezeigt und/oder mit einem Bezugszeichen versehen sein. Nichtsdestotrotz können Merkmale, welche erst in einer oder mehreren der nachfolgenden Figuren gezeigt sind, auch bereits in dieser oder einer vorangegangenen Figur vorhanden sein.

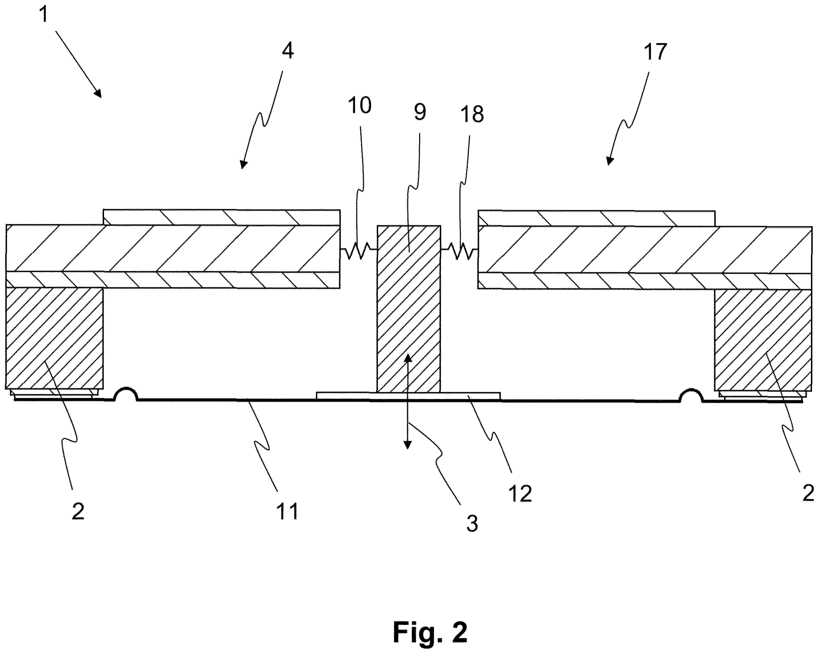

Figur 2 zeigt eine schematische Seitenansicht eines MEMS-Schallwandlers 1 mit zwei Piezoelementen 4, 17. Wie bereits erläutert, wird hier nicht mehr auf alle Merkmale eingegangen. Beispielsweise sind die Merkmale des ersten Piezoelements 4 bereits zur Figur 1 beschrieben. Vorteilhafterweise sind die beiden hier gezeigten Piezoelemente 4, 17 zueinander gleich ausgebildet. Infolgedessen weist somit das zweite Piezoelement 17 die gleichen Merkmale wie das erste Piezoelement 4 auf.

Wie hier weiterhin zu sehen ist, sind die beiden Piezoelemente 4, 17 über ein einziges Koppelelement 9 mit der Membran 11 gekoppelt. Des Weiteren ist zwischen dem ersten Piezoelement 4 und dem Koppelelement 9 das erste Federelement 10 und zwischen dem zweiten Piezoelement 17 und dem Koppelelement 9 ein zweites Federelement 18 angeordnet. Die beiden Piezoelemente der 4, 17 lenken somit beide die Membran 11 über das hier gezeigte Koppelelement 9 aus. Zusätzlich oder alternativ können auch die Auslenkungen der Membranen 11 über das Koppelelement 9 auf beide Piezoelemente 4, 17 übertragen werden.

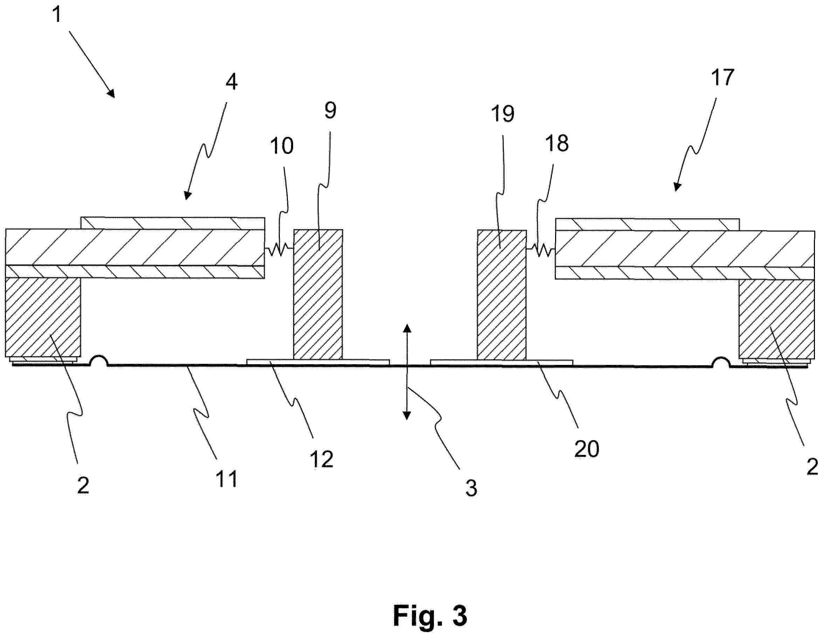

Figur 3 zeigt einen MEMS-Schallwandler 1 mit zwei Piezoelementen 4, 17 und zwei Koppelelementen 9, 19. Hier wird ebenfalls nicht nochmals auf die einzelnen Merkmale eingegangen, wenn diese bereits aus zumindest einer vorangegangenen Figur bekannt sind.

Wie in dem vorliegenden Ausführungsbeispiel gezeigt ist, ist das erste Piezoelement 4 mittels dem ersten Koppelelement 9 mit der Membran 11 gekoppelt. Zwischen dem ersten Koppelelement 9 und dem ersten Piezoelement 4 ist außerdem das erste Federelement 10 angeordnet. Zusätzlich oder alternativ ist zwischen dem ersten Koppelelement 9 und der Membran 11 die erste Koppelplatte 12 angeordnet.

Des Weiteren ist das zweite Piezoelement 17 mittels einem zweiten Koppelelement 19 mit der Membran 11 gekoppelt. Zwischen dem zweiten Piezoelement 17 und dem zweiten Koppelelement 19 ist das zweite Federelement 18 angeordnet. Zwischen dem zweiten Koppelelement 19 und der Membran 11 ist eine zweite Koppelplatte 20 angeordnet. Durch das hier gezeigte Ausführungsbeispiel können die beiden Piezoelemente 4, 17 in einem gewissen Maße unabhängig voneinander mit der Membran 11 gekoppelt werden.

Alternativ zu dem hier gezeigten Ausführungsbeispiel können die beiden hier gezeigten Koppelelemente 9, 19 mittels einer einzigen Koppelplatte 12, 20 mit der Membran 11 gekoppelt werden. Beispielsweise können die beiden hier gezeigten Koppelplatten 12, 20 zu einer einzigen Koppelplatte 12, 20 zusammengefasst werden.

In Figur 4 ist eine schematische, seitliche Schnittansicht eines schichtweisen Aufbaus eines MEMS-Schallwandlers 1 gezeigt. Die Figur 4 zeigt den schematischen Aufbau des MEMS-Schallwandlers 1 der Figur 1, allerdings ohne den Bereich rechts neben dem Koppelelement 9. Das heißt, der rechte Abschnitt des Trägers 2 der Figur 1 ist hier in Figur 4 nicht gezeigt.

In Figur 4 ist eine Aufbaurichtung 21 gezeigt. In dieser Aufbaurichtung 21 können die hier gezeigten Schichten des MEMS-Schallwandlers 1 aufgebaut werden. Zu beachten ist hier auch, dass die Schichten über die komplette Breite des hier gezeigten MEMS-Schallwandlers 1 angeordnet werden können. Das heißt, dass die hier gezeigten nicht schraffierten Bereiche erst im Nachhinein ausgebildet werden.

Auf einen Träger 2, der sich zu Beginn des Herstellungsverfahrens über die komplette Breite des hier gezeigten MEMS-Schallwandlers 1 erstrecken kann, kann gemäß der Aufbaurichtung 21 eine erste Elektrodenschicht 22 angeordnet werden. Beim weiteren Herstellungsverfahren kann auf der ersten Elektrodenschicht 22 eine erste Piezoschicht 5 ausgebildet werden. Auf die erste Piezoschicht 5 kann eine zweite Elektrodenschicht 24 ausgebildet werden. Auf die zweite Elektrodenschicht 24 kann eine zweite Piezoschicht 25 ausgebildet werden. Auf die zweite Piezoschicht 25 kann eine dritte Elektrodenschicht 26 ausgebildet werden. In der Figur 1 ist lediglich die erste Piezoschicht 5 gezeigt. In der hier gezeigten Figur 4 ist das Piezoelement 4 detaillierter gezeigt. Vorteilhafterweise kann das Piezoelement 4 mehrere Piezoschichten 5, 25 aufweisen. Beispielsweise kann das Piezoelement 4 zwischen zwei und sechs Piezoschichten 5, 25 aufweisen. In einer vorteilhaften Ausführung kann das Piezoelement 4 vier Piezoschichten 5, 25 aufweisen. Die hier erläuterten Elektrodenschichten 22, 24, 26 dienen dazu, elektrische Signale zu der zumindest einen Piezoschicht 5, 25 zu führen und/oder von der zumindest einen Piezoschicht 5, 25 abzuführen.

Gemäß dem vorliegenden Ausführungsbeispiel sind das hier gezeigte Koppelelement 9 und das hier gezeigte Piezoelement 4 zueinander gleich schichtweise aufgebaut. Infolgedessen weist das hier gezeigte Koppelelement 9 einen Abschnitt des Trägers 2, die erste Elektrodenschicht 22, die erste Piezoschicht 5, die zweite Elektrodenschicht 24, die zweite Piezoschicht 25 und/oder die dritte Elektrodenschicht 26 auf. Allerdings haben diese besagten Schichten beim Koppelelement 9 lediglich die Wirkung, dass diese das Koppelelement 9 aufbauen. Es ist für das Herstellungsverfahren vorteilhaft, wenn das Koppelelement 9 und das zumindest eine Piezoelement 4 zueinander gleich schichtweise aufgebaut sind. Hierdurch können das Koppelelement 9 und das zumindest eine Piezoelement 4 gleichzeitig zueinander ausgebildet werden. In einem nach dem Aufbau des Koppelelements 9 und des zumindest einen Piezoelements 4 folgenden Bearbeitungsschritt können beide voneinander, beispielsweise mittels Ätzen, voneinander getrennt werden.

Zusätzlich kann eine erste Isolationsschicht 27 angeordnet werden. Des Weiteren kann eine Kontaktierungsschicht 29 angeordnet werden, um die elektrischen Signale zu der zumindest einen Piezoschicht 5, 25 zu leiten und/oder um die elektrischen Signale von der zumindest einen Piezoschicht 5, 25 wegzuleiten. Weiterhin zusätzlich oder alternativ kann eine zweite Isolationsschicht 28 ausgebildet werden. Die zumindest eine Isolationsschicht 27, 28 dient dazu, um elektrische Leiter, beispielsweise die Kontaktierungsschicht und/oder die zumindest eine Piezoschicht 5, 25, elektrisch zu isolieren.

Nachdem diese Schichten ausgebildet sind, kann, beispielsweise mittels Ätzens, ein erster Freiraum 30 ausgebildet werden. Der erste Freiraum 30 dient dazu, dass das hier gezeigte Piezoelement 4 vom Koppelelement 9 getrennt wird und dass sich das Piezoelement 4, insbesondere gegenüber dem Träger 2, auslenken kann. Das Piezoelement 4 und das Koppelelement 9 werden nach der Ausbildung des ersten Freiraums 30 mit Hilfe des ersten Federelements 10 miteinander gekoppelt.

Auf die zumindest eine Piezoschicht 5, 25 und/oder auf die zumindest eine hier gezeigte Elektrodenschicht 22, 24, 26 wird die zumindest eine Strukturschicht 6 ausgebildet, die aus einem Polymer ist. Gemäß dem vorliegenden Ausführungsbeispiel ist auf der ersten Strukturschicht 6 eine zweite Strukturschicht 31 angeordnet. Durch diese mehreren Lagen aus den Strukturschichten 6, 31 kann die Dicke 34 der daraus resultierenden Schicht vergrößert werden. Die zumindest eine Strukturschicht 6, 31 kann beispielsweise in Form einer Folie, insbesondere einer Polymerfolie, auf die zumindest eine Piezoschicht 5, 25 und/oder auf die zumindest eine Elektrodenschicht 22, 24, 26 und/oder auf die zumindest eine Isolationsschicht 27, 28 und/oder auf die zumindest eine Kontaktierungsschicht 29 auflaminiert werden. So kann beispielsweise die Dicke 34 der zumindest einen Strukturschicht 6, 31 die doppelte Dicke der Polymerfolie aufweisen und die Polymerfolie zweimal auflaminiert werden, so dass die hier gezeigten beiden Strukturschichten 6, 31 ausgebildet werden. Die beiden Strukturschichten 6, 31 können allerdings als eine einzige Strukturschicht 6, 31 angesehen werden.

In diesem Ausführungsbeispiel sind zwei Piezoschichten 5, 25 gezeigt. Wenn die Piezoschichten 5, 25 aus Scandium-Aluminium-Nitrit ausgebildet sind, ist es vorteilhaft, wenn das zumindest eine Piezoelement 4, 17 zwischen zwei und sechs, insbesondere vier, Piezoschichten 5, 25 aufweist.

Nach dem Ausbilden der zumindest einen Strukturschicht 6, 31 kann darin ein zweiter Freiraum 32 ausgebildet werden. Über diesen zweiten Freiraum 32 kann eine Verbindung zur hier gezeigten Kontaktierungsschicht 29 ausgebildet werden.

In der hier gezeigten Figur 4 ist weiterhin das erste Federelement 10 gezeigt. Dieses erste Federelement 10 ist hier durch die erste und zweite Strukturschicht 6, 31 ausgebildet.

Des Weiteren ist hier die Kompensationsschicht 7 gezeigt. Diese erstreckt sich in Längsrichtung des Piezoelements 4 vom Träger 2 bis zum Federelement 10.

Die zur Figur 4 beschriebenen Schichten können zumindest teilweise mit Hilfe eines Lithographieverfahrens ausgebildet werden.

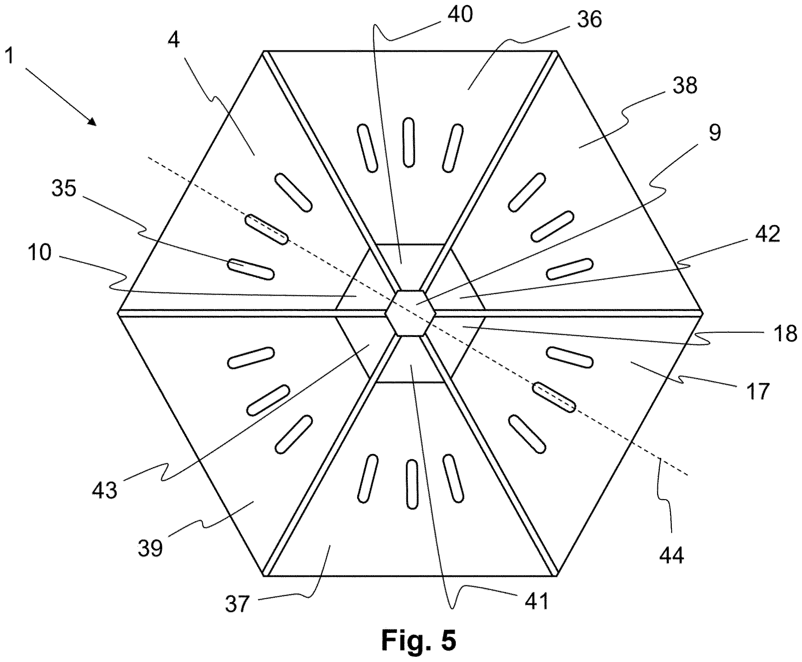

Figur 5 zeigt ein Ausführungsbeispiel des MEMS-Schallwandlers 1 in einer Draufsicht. Die Draufsicht ist hier parallel bzw. entlang bzw. in Richtung der Hubachse 3.

Hier sind insgesamt sechs Piezoelemente 4, 17, 36 - 39 gezeigt, die in einen, insbesondere regelmäßigen Polygon, hier Sechseck, angeordnet sind.

Gemäß dem vorliegenden Ausführungsbeispiel sind die Piezoelemente 4, 17, 36 - 39 sind jeweils mittels eines Federelements 10, 18, 40 - 43 mit dem Koppelelement 9 gekoppelt. Hiermit sind hier ebenfalls sechs Federelemente 10, 18, 40 - 43 gezeigt. Des Weiteren ist hier lediglich ein Koppelelement 9 vorhanden. Alternativ kann auch zumindest ein weiteres Koppelelement vorhanden sein, so dass die Piezoelemente 4, 17, 36 - 39 mittels mehrerer Koppelelemente mit der Membran 11 gekoppelt werden können.

Des Weiteren sind hier Aussparungen 35 gezeigt. Zumindest ein Piezoelement 4, 17, 36 - 39 kann zumindest eine Aussparung 35 aufweisen. Mittels der Aussparung 35 kann die mechanische Eigenschaft, beispielsweise die mechanische Spannung und/oder Bewegungseigenschaften, des Piezoelements 4, 17, 36 - 39 angepasst werden. Die zumindest eine Aussparung 35 kann sich hierbei in der Piezoschicht, Strukturschicht und/oder Kompensationsschicht des entsprechenden Piezoelements 4, 17, 36 - 39 erstrecken.

Ferner ist hier eine Schnittebene 44 gezeigt. Beispielsweise zeigt die Figur 2 den Schnitt entlang der Schnittebene 44. Allerdings sind in Figur 2 beispielsweise die Aussparungen 35 nicht gezeigt.

### Bezugszeichenliste

- 1: MEMS-Schallwandler
- 2: Träger
- 3: Hubachse
- 4: erstes Piezoelement
- 5: erste Piezoschicht
- 6: erste Strukturschicht
- 7: Kompensationsschicht
- 8: freies Ende
- 9: erstes Koppelelement
- 10: erstes Federelement
- 11: Membran
- 12: erste Koppelplatte
- 13: Membranrahmen
- 14: neutrale Ebene
- 15: Oberseite
- 16: Unterseite
- 17: zweites Piezoelement
- 18: zweites Federelement
- 19: zweites Koppelelement
- 20: zweite Koppelplatte
- 21: Aufbaurichtung
- 22: erste Elektrodenschicht
- 24: zweite Elektrodenschicht
- 25: zweite Piezoschicht
- 26: dritte Elektrodenschicht
- 27: erste Isolationsschicht
- 28: zweite Isolationsschicht
- 29: Kontaktierungsschicht
- 30: erster Freiraum
- 31: zweite Strukturschicht
- 32: zweiter Freiraum
- 33: Länge
- 34: Dicke
- 35: Aussparung
- 36: drittes Piezoelement
- 37: viertes Piezoelement
- 38: fünftes Piezoelement
- 39: sechstes Piezoelement
- 40: drittes Federelement
- 41: viertes Federelement
- 42: fünftes Federelement
- 43: sechstes Federelement
- 44: Schnittebene

## Patentansprüche

1. MEMS-Schallwandler (1), insbesondere zum Erzeugen und/oder Erfassen von Schallwellen im hörbaren Wellenlängenspektrum und/oder im Ultraschallbereich, mit
einem Träger (2) und
mit zumindest einem am Träger (2) angeordneten und in Richtung einer Hubachse (3) auslenkbaren Piezoelement (4, 17),
das zumindest eine Piezoschicht (5, 25) und zumindest eine Strukturschicht (6, 31) aufweist, wobei mittels der zumindest einen Piezoschicht (5, 25) elektrische Signale und Auslenkungen des Piezoelements (4) ineinander umwandelbar sind,
**dadurch gekennzeichnet,**
**dass** die zumindest eine Piezoschicht (5, 25) aus Scandium-Aluminium-Nitrit ausgebildet ist.

2. MEMS-Schallwandler nach dem vorherigen Anspruch, **dadurch gekennzeichnet, dass** die zumindest eine Strukturschicht (6, 31) aus einem Polymer, insbesondere einem Polyamid, ausgebildet ist.

3. MEMS-Schallwandler nach einem oder mehreren der vorherigen Ansprüche,
**dadurch gekennzeichnet, dass** das Piezoelement (4, 17) eine Kompensationsschicht (7) zum Ausgleichen von mechanischen Spannungen der zumindest einen Strukturschicht (6, 31) und/oder zum Strecken der zumindest einen Strukturschicht (6, 31) aufweist und/oder
dass die Kompensationsschicht (7) aus einem Metall, insbesondere Gold, und/oder Siliziumdioxid, insbesondere TEOS, ausgebildet ist und/oder
dass die Kompensationsschicht (7) eine Dicke (34) zwischen 0,2 µm und 4 µm, insbesondere zwischen 0,5 µm und 3 µm, vorzugsweise zwischen 0,6 µm und 2 µm, vorzugsweise zwischen 1 µm und 2 µm, aufweist und/oder
dass sich die Kompensationsschicht (7) in einer Längsrichtung des Piezoelements (4, 17) bis an den Träger (2) und/oder an das freie Ende (8) des Piezoelements (4, 17) erstreckt.

4. MEMS-Schallwandler nach einem oder mehreren der vorherigen Ansprüche, **dadurch gekennzeichnet, dass** in Richtung der Hubachse (3) die Piezoschicht (5, 25) zwischen dem Träger (2) und der Strukturschicht (6, 31) angeordnet ist und/oder
dass die Strukturschicht (6, 31) zwischen der Piezoschicht (5, 25) und der Kompensationsschicht (7) angeordnet ist und/oder
dass das Piezoelement (4, 17) in dessen Längsrichtung eine Länge (33), insbesondere vom Träger (2) bis zu einem freien Ende (8) des Piezoelements (4, 17), zwischen 0,5 mm und 2 mm aufweist.

5. MEMS-Schallwandler nach einem oder mehreren der vorherigen Ansprüche, **dadurch gekennzeichnet, dass** das zumindest eine Piezoelement (4, 17) mehrere, insbesondere zwischen zwei und sechs, vorzugsweise vier, Piezoschichten (5, 25) umfasst und/oder
dass das zumindest eine Piezoelement (4, 17) zumindest eine Elektrodenschicht (22, 24, 26) umfasst und/oder
dass das zumindest eine Piezoelement (4,17) zumindest eine Isolationsschicht (27, 28) umfasst und/oder
dass das zumindest eine Piezoelement (4, 17) sandwichartig aus den mehreren Piezoschichten (5, 25) und den Elektrodenschichten (22, 24, 26) ausgebildet ist.

6. MEMS-Schallwandler nach einem oder mehreren der vorherigen Ansprüche, **dadurch gekennzeichnet, dass** der MEMS-Schallwandler (1) ein Koppelelement (9, 19) umfasst, mit dem das zumindest eine Piezoelement (4, 17) mit einer Membran (11) koppelbar ist, und/oder
dass das Piezoelement (4, 17) und das Koppelelement (9, 19) mittels zumindest eines Federelements (10, 18) miteinander gekoppelt sind, wobei das zumindest eine Federelement (10, 18) in Längsrichtung des Piezoelements (4, 17) vorzugsweise zwischen der Strukturschicht (6, 31) und dem Koppelelement (9, 19) angeordnet ist und/oder dass das Federelement (10, 18), vorzugsweise ausschließlich, durch die Strukturschicht (6, 31) und/oder dem Polymer ausgebildet ist.

7. MEMS-Schallwandler nach einem oder mehreren der vorherigen Ansprüche, **dadurch gekennzeichnet, dass** das Piezoelement (4, 17) und das Koppelelement (9, 19) zueinander denselben schichtweisen Aufbau aufweisen.

8. MEMS-Schallwandler nach einem oder mehreren der vorherigen Ansprüche, **dadurch gekennzeichnet, dass** die Strukturschicht (6, 31) zwischen 10µm und 50µm dick ist und/oder
dass die Strukturschicht (6, 31) aus dem Polymer ein E-Modul zwischen 2 und 50 GPa, insbesondere zwischen 2 - 5 GPa, vorzugsweise zwischen 3,5 und 4 GPa aufweist, und/oder
dass die Strukturschicht (6, 31) aus dem Polymer eine Zugfestigkeit zwischen 70 und 100 MPa, insbesondere zwischen 85 und 95, MPa aufweist und/oder
dass die Strukturschicht (6, 31) aus dem Polymer derart ausgebildet ist, dass eine Elongation zwischen 3% und 10% ausgebildet werden kann.

9. MEMS-Schallwandler nach einem oder mehreren der vorherigen Ansprüche, **dadurch gekennzeichnet, dass** das zumindest eine Piezoelement (4, 17) zumindest eine Aussparung (35) aufweist, wobei die Aussparung vorzugsweise in der zumindest einen Piezoschicht (5, 25), in der zumindest eine Elektrodenschicht (22, 24, 26), in der zumindest einen Isolationsschicht (27, 28), in der zumindest einen Strukturschicht (6) und/oder in der zumindest einen Kompensationsschicht (7) angeordnet ist.

10. MEMS-Schallwandler nach einem oder mehreren der vorherigen Ansprüche, **dadurch gekennzeichnet, dass** die Kompensationsschicht (7) eine gleiche oder höhere mechanische Spannung als die zumindest eine Strukturschicht (6, 31) aufweist, wobei die mechanische Spannung der Kompensationsschicht (7) der mechanischen Spannung der zumindest einen Strukturschicht (6, 31) entgegenwirkt und/oder
dass ein mechanischer Spannungszustand der Kompensationsschicht (7) einer mechanischen Spannung der zumindest einen Strukturschicht (6, 31) und/oder der zumindest einen Piezoschicht (5, 25) entgegenwirkt, diese kompensiert und/oder ausgleicht, wobei die Kompensationsschicht (7) vorzugsweise eine mechanische Spannung zwischen 50 MPa und 1000 MPa, insbesondere von 240 MPa, aufweist.

11. Verfahren zur Herstellung eines MEMS-Schallwandlers (1), insbesondere zum Erzeugen und/oder Erfassen von Schallwellen im hörbaren Wellenlängenspektrum und/oder im Ultraschallbereich, der vorzugsweise gemäß einem oder mehreren der vorherigen Ansprüche ausgebildet wird,
bei dem auf einem Träger (2) zumindest ein Piezoelement (4, 17) ausgebildet wird, das zumindest eine Piezoschicht (5, 25) und zumindest eine damit gekoppelte Strukturschicht (6, 31) umfasst,
**dadurch gekennzeichnet,**
**dass** die zumindest eine Piezoschicht (5, 25) aus Scandium-Aluminium-Nitrit ausgebildet wird.

12. Verfahren nach dem vorherigen Anspruch, **dadurch gekennzeichnet, dass** zur Ausbildung der zumindest einen Strukturschicht (6, 31) ein Polymer auf der Piezoschicht (5, 25) angeordnet wird und/oder
dass die Strukturschicht (6, 31) aus dem Polymer auf einer dem Träger (2) abgewandten Seite der Piezoschicht (5, 25) angeordnet wird und/oder dass das zumindest eine Piezoelement (4, 17) mit mehreren, insbesondere zwischen zwei und sechs, insbesondere vier, Piezoschichten (5, 25) ausgebildet wird und/oder dass das zumindest eine Piezoelement (4, 17) sandwichartig aus den mehreren Piezoschichten (5, 25) und zumindest einer Elektrodenschicht (22, 24, 26) ausgebildet wird und/oder dass beim Ausbilden des zumindest einen Piezoelements (4, 17) zumindest eine Isolationsschicht (27, 28) angeordnet wird.

13. Verfahren nach einem oder mehreren der vorherigen Ansprüche, **dadurch gekennzeichnet, dass** die Strukturschicht (6, 31) aus dem Polymer auf der zumindest einen Piezoschicht (5, 25) angeordnet wird, nachdem die Piezoschicht (5, 25) und/oder ein Koppelelement (9, 19) ausgebildet sind und/oder nachdem der Träger (2), die Piezoschicht (5, 25) und/oder das Koppelelement (9, 19), insbesondere mittels Ätzens, nachbearbeitet, insbesondere voneinander getrennt, sind, und/oder dass das Piezoelement (4, 17) und das Koppelelement (9, 19) zusammen schichtweise ausgebildet werden, wobei dies vorzugsweise auf dem Träger (2) erfolgt und/oder dass nach dem schichtweisen Aufbauen des Piezoelements (4, 17) und des Koppelelements (9, 19) diese, insbesondere mittels Ätzens, zumindest abschnittweise voneinander getrennt werden.

14. Verfahren nach einem oder mehreren der vorherigen Ansprüche, **dadurch gekennzeichnet, dass** die zumindest eine Strukturschicht (6, 31) aus dem Polymer auf die Piezoschicht (5, 25) und/oder das Koppelelement (9, 19), insbesondere in Form einer, vorzugsweise selbstklebenden, Polymerfolie, auflaminiert wird und/oder
dass das Auflaminieren der Strukturschicht (6, 31) aus dem Polymer bei einer Temperatur zwischen 70°C und 90°C erfolgt und/oder
dass nach dem Auflaminieren ein Aushärtungsschritt des Polymers erfolgt, wobei dieser Aushärtungsschritt vorzugsweise bei einer Temperatur zwischen 150°C und 200°C und/oder für eine Dauer zwischen 0,5 und 2 Stunden erfolgt.

15. Verfahren nach einem oder mehreren der vorherigen Ansprüche, **dadurch gekennzeichnet, dass** zwei Strukturschichten (6, 31) ausgebildet werden, die vorzugsweise übereinander angeordnet sind und/oder die aus dem gleichen oder einem unterschiedlichen Polymer ausgebildet sind und/oder
dass auf die Strukturschicht (6, 31) eine Kompensationsschicht (7) angeordnet wird.
